# EUROPEAN PATENT APPLICATION

(11) **EP 2 618 384 A1**
(43) Date of publication of application: **24.07.2013**
(21) Application number: 11825324.4
(22) Date of filing: 27.04.2011
(51) Int. Cl.: H01L 31/042

(54) **SOLAR PHOTOVOLTAIC DEVICE AND A PRODUCTION METHOD THEREFOR**

(30) Priority: 16.09.2010 KR 20100091278
(71) Applicant: LG Innotek Co., Ltd., Seoul 100-714 (KR)
(72) Inventor: LEE, JinWoo, Seoul 100-714 (KR)
(74) Representative: Novagraaf Technologies
(86) International application number: PCT/KR2011/003123
(87) International publication number: WO 2012/036364

(57) **Abstract**

Disclosed are a solar cell apparatus and a method of fabricating the same. The solar cell apparatus includes a substrate, a back electrode layer on the substrate, a light absorbing layer on the back electrode layer, and a front electrode layer on the light absorbing layer. The back electrode layer is provided therein with a through hole extending in one direction. The through hole includes a first region comprising first protrusions extending inwardly from an inner lateral side thereof, and a second region comprising a cutting surface formed more outward than an end portion of each first protrusion.

## Description

The embodiment relates to a solar cell apparatus and a method of fabricating the same.

### [Background Art]

Recently, as energy consumption is increased, a solar cell has been developed to convert solar energy into electrical energy.

In particular, a CIGS-based solar cell, which is a PN hetero junction apparatus having a substrate structure including a glass substrate, a metallic back electrode layer, a P type CIGS-based light absorbing layer, a high resistance buffer layer, and an N type window layer, has been extensively used.

### [Disclosure]

### [Technical Problem]

The embodiment provides a solar cell apparatus capable of preventing short and representing improved electrical characteristics and high photoelectric conversion efficiency, and a method of fabricating the same.

### [Technical Solution]

According to the embodiment, there is provided a solar cell apparatus including a substrate, a back electrode layer on the substrate, a light absorbing layer on the back electrode layer, and a front electrode layer on the light absorbing layer. The back electrode layer is provided therein with a through hole extending in one direction. The through hole includes a first region comprising first protrusions extending inwardly from an inner lateral side thereof, and a second region comprising a cutting surface formed more outward than an end portion of the first protrusions.

According to the embodiment, there is provided a solar cell apparatus including g a substrate, a plurality of back electrodes provided on the substrate, light absorbing parts provided on the back electrodes, respectively, and a plurality of front electrodes provided on the light absorbing parts, respectively. A lateral side of the back electrodes includes a first region in which first protrusions extending in a lateral direction are arranged, and a second region in which second protrusions shorter than the first protrusions are arranged.

According to the embodiment, there is provided a method of fabricating a solar cell apparatus. The method includes forming a back electrode layer on a substrate, primarily patterning the back electrode layer by using a laser, and secondarily patterning the back electrode layer through a mechanical scheme.

### [Advantageous Effects]

As described above, according to the method of fabricating the solar cell apparatus of the embodiment, a primary patterning process is performed by using a laser, and a secondary patterning process is performed through a mechanical scheme. After the primary patterning process has been performed, a portion of the back electrode layer can be spaced apart from the substrate. In this case, the portion of the back electrode layer spaced apart from the substrate can be removed.

Therefore, according to the solar cell apparatus of the embodiment, the short and the leakage current, which are caused by the burr formed when the portion of the back electrode layer is spaced apart from the substrate, can be prevented. Therefore, the solar cell apparatus according to the embodiment can represent improved electrical characteristics and high photoelectric conversion efficiency.

In addition, according to the solar cell apparatus of the embodiment, the through holes may be formed in the back electrode layer by the laser through the primary patterning process. In this case, protrusions are formed inwardly from the inner lateral side of the through holes.

A portion of the protrusions can be spaced apart from the substrate, and the protrusions spaced apart from the substrate can be removed through the secondary patterning process.

Further, the solar cell apparatus of the embodiment may include a region having a cutting surface therein, and may include protrusions shorter than other protrusions.

### [Description of Drawings]

FIGS. 1 to 9 are sectional views showing the fabricating process of a solar cell apparatus according to the embodiment;

FIG. 10 is a plan view showing a bur region according to another embodiment; and

FIG. 11 is a plan view showing a bur region according to still another embodiment.

FIG. 12 is a plan view showing a bur region according to still another embodiment.

### [Best Mode]

### [Mode for Invention]

In the description of the embodiments, it will be understood that, when a substrate, a layer, a film, or an electrode is referred to as being "on" or "under" another substrate, another layer, another film, or another electrode, it can be "directly" or "indirectly" on the other substrate, the other layer, the other film, or the other electrode, or one or more intervening layers may also be present. Such a position of each component has been described with reference to the drawings. The thickness and size of each component shown in the drawings may be exaggerated, omitted or schematically drawn for the purpose of convenience or clarity. In addition, the size of elements does not utterly reflect an actual size.

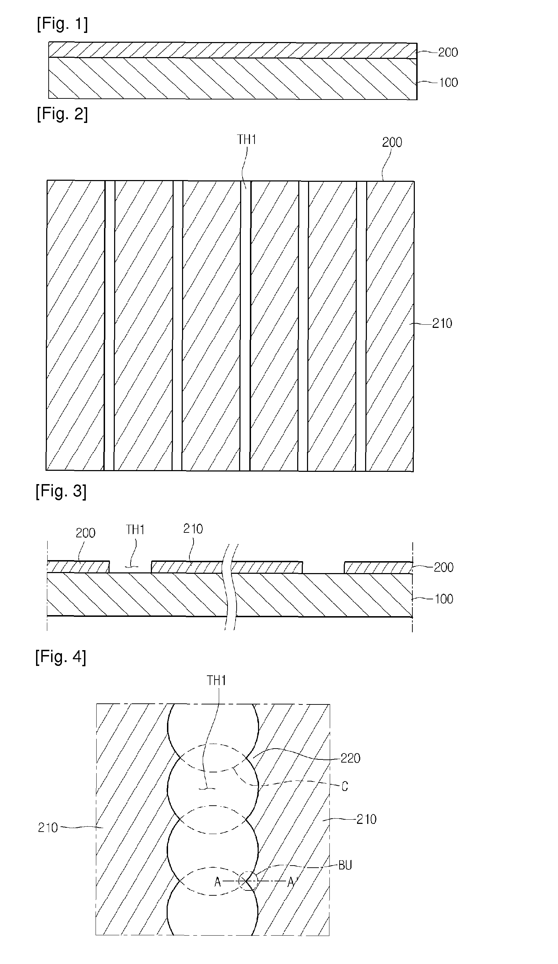

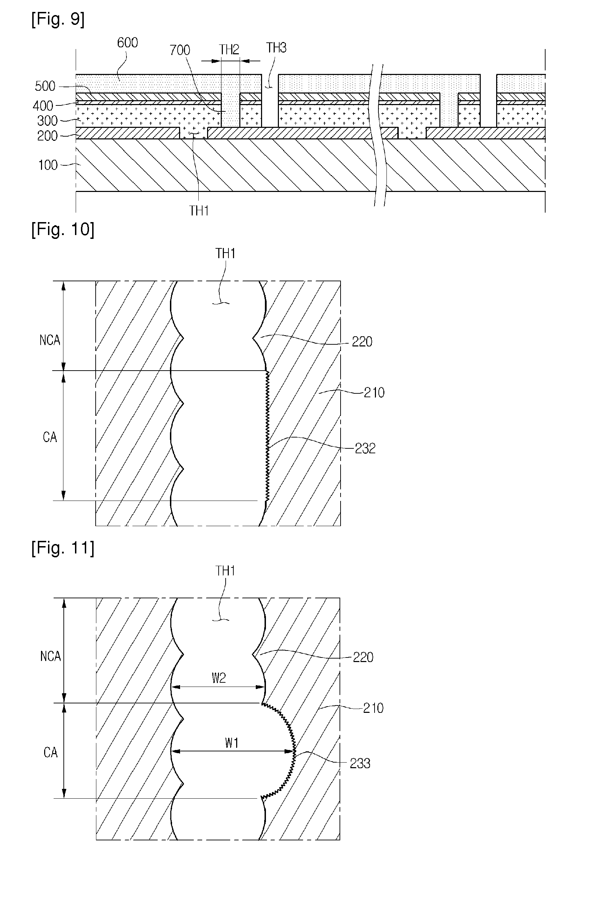

FIGS. 1 to 9 are sectional views showing the fabricating process of a solar cell apparatus according to the embodiment, FIG. 10 is a plan view showing a bur region according to another embodiment, and FIG. 11 is a plan view showing a bur region according to still another embodiment.

Referring to FIG. 1, a back electrode layer 200 is formed on a substrate 100.

The support substrate 100 has a plate shape. The support substrate 100 may include an insulator. For example, the support substrate 100 may include a glass substrate, a plastic substrate, or a metallic substrate. In more detail, the support substrate 100 may include a soda lime glass substrate. In addition, the support substrate 100 may be transparent. The support substrate 100 may be rigid or flexible.

The back electrode layer 200 is provided on the support substrate 100. The back electrode layer 200 is formed by depositing molybdenum (Mo) on the top surface of the support substrate 100. The back electrode layer 200 may include at least two layers. In this case, each layer may include homogeneous metal or heterogeneous metal.

The thickness of the back electrode layer 200 may be in the range of about 500nm to abut 1000nm. The back electrode layer 200 may be uniformly formed on the entire top surface of the support substrate 100.

Referring to FIGS. 2 to 5, the back electrode layer 200 is primarily patterned.

The back electrode layer 200 is patterned by a laser. Accordingly, as shown in FIG. 2, the back electrode layer 200 is formed therein with a plurality of first through holes TH1 extending in a first direction. The first through holes TH1 extend in parallel to each other while being spaced apart from each other.

The first through holes TH1 are open regions to expose the top surface of the support substrate 100. The width of the first through holes TH1 may be in the range of about 80µm to about 200µm.

The back electrodes 210 are spaced apart from each other by the first through holes TH1. The back electrodes 210 may are arranged in the form of a stripe.

In addition, the back electrodes 210 may be arranged in the form of a matrix. In this case, the first through holes TH1 are arrange in the form of a lattice when viewed in a plane view.

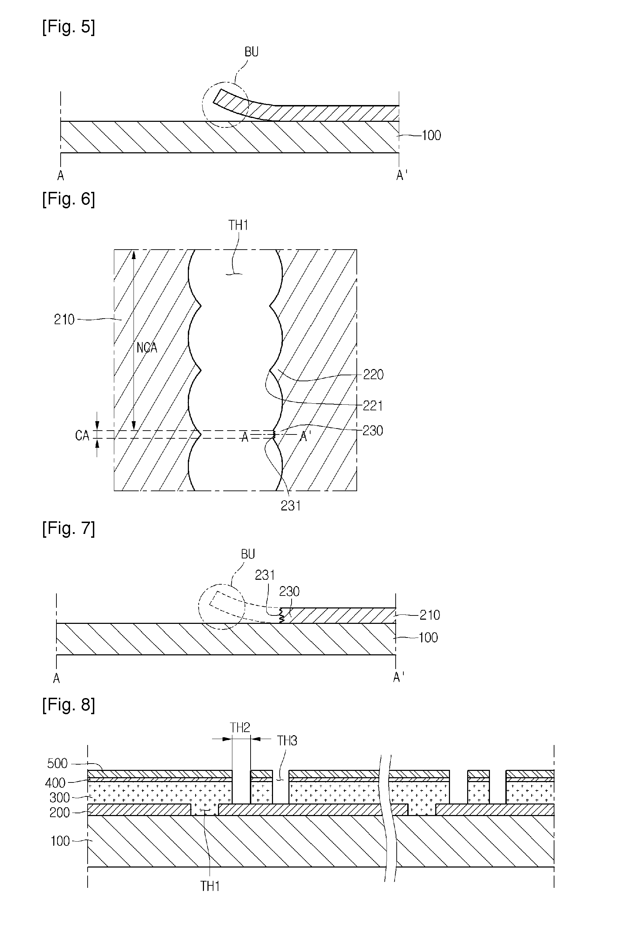

FIG. 4 is an enlarged plan view showing the first through holes TH1. FIG. 5 is a sectional view taken along line A-A' of FIG. 4.

As shown in FIG. 4, a plurality of protrusions 220 protrude from an inner lateral side of the first through hole in a lateral direction. The first through holes TH1 are formed by irradiating the laser onto the back electrode layer 200. The laser is irradiated onto the back electrode layer 200 with a discrete intensity while moving. Therefore, the first through holes TH1 may have a shape in which a plurality of circles C are overlapped with each other.

Therefore, the protrusions 220 are formed corresponding to the overlap region of circles C. In other words, the back electrode layers 200 remain between the circles C without being removed. The remaining part forms the protrusions 220.

Therefore, the lateral side of the first through holes TH1 includes a curved surface having a concave pattern. In other word, the inner lateral side between the protrusions 220 has a concave shape when viewed in a plan view.

As shown in FIGS. 4 and 5, burrs BU may be formed on the back electrode layer 200. The burr BU is a portion of the back electrode layer 200 spaced apart from the support substrate 100. In other words, when the first through holes TH1 are formed, the burr BU may be formed.

For example, the back electrode layer 200 may be spaced apart from the support substrate 100 by high temperature-heat generated from the laser. In other words, the back electrode layer 200 may be spaced apart from the support substrate 100 due to the thermal expansion coefficient difference between the back electrode layer 200 and the support substrate 100. In addition, when the laser is incident onto the support substrate 100 while being tilted instead of a perpendicular direction, the burr BU may be easily formed.

The burr BU may be formed at a portion of the protrusion 220. In other words, a portion of the protrusions 220 may be spaced apart from the support substrate 100.

The back electrode layer 200 is divided into a plurality of back electrodes 210 by the first through holes TH1. In other words, the first through holes TH1 define the back electrodes 210. The back electrodes 210 may be spaced apart from each other.

The protrusions 220 protrude outward from the lateral side of the back electrodes 210. In other words, the inner lateral side of the first through holes TH1 is the same as the lateral side of the back electrodes 210.

Referring to FIGS. 6 and 7, the back electrode layer 200 is secondarily patterned through a mechanical scheme. In more detail, impact is applied to the inner lateral side of the first through holes TH1 through the secondary patterning process. In addition, the mechanical impact is applied to the protrusions 220 through the secondary patterning process.

Therefore, a portion of the back electrode layer 200 is removed. In more detail, the burr BU may be removed through the secondary patterning process.

A tip may be used in the secondary patterning process. The width of the tip may correspond to the width of the first through holes TH1. The width of the tip may be smaller than the width of the first through holes TH1. In addition, the width of the tip may be greater than the width of the first through holes TH1.

The tip is provided in the first through holes TH1, and moves along the first through holes TH1. Simultaneously, the tip applies mechanical impact to the lateral side of the through holes TH1 and the protrusions 220.

In this case, the tip applies impact to the inner lateral side of the first through holes TH1 and the protrusions 220 with force to remove only the burr BU.

Therefore, a portion or an entire portion of the protrusion having the burr BU is cut, so that a cutting surface 231 is formed in the first through holes TH1. Since the cutting surface 231 is formed by cutting the protrusion having the burr BU, the cutting surface 231 is formed at the outside of the first through hole TH1 instead of the end portion 221 of the protrusions 220 (the first protrusions) without the burr BU.

Since the cutting surface 231 is formed due to the mechanical impact, the cutting surface 231 may represent high roughness. In other words, the cutting surface 231 may represent the roughness higher than that of the internal side between the first protrusions 220.

The region having the cutting surface 231 is defined as a cutting region CA. In other words, the cutting region CA includes the cutting surface 231. A remaining region except for the cutting region CA may be defined as a non-cutting region NCA. The non-cutting region NCA is formed through the primary patterning process, and the cutting region CA is formed through the secondary patterning process.

The cutting region CA may include protrusions 230 (second protrusions) having a shorter length due to the cutting of the end portion thereof. In other words, the burrs BU are formed at the end portion of several protrusions 220. As the end portion of the protrusions 220 having the burrs BU is cut through the patterning process, the second protrusions 230 having a shorter length can be formed. Therefore, the second protrusions 230 may have a length shorter than that of the first protrusions 220. In addition, the cutting surface 231 is provided at the end portion of the second protrusions 230.

In the present embodiment, the cutting area CA and the non-cutting area NCA are divided in the extension direction of the first through holes TH1, but the embodiment is not limited thereto. That is, the area having the cutting surface 231 may be defined as a cutting area CA and a remaining area except for the cutting area CA may be defined as the non-cutting area NCA.

Since a portion of the second protrusions 230 is cut through the secondary patterning process, the second protrusion 230 has a smaller area. In other words, the second protrusions 230 have an area smaller than that of the first protrusions 220.

For example, the area of the second protrusions 230 may be about 1% to about 50% of the area of the first protrusions 220.

Different from FIGS. 6 and 7, referring to FIG. 10, the burrs BU may be formed on the entire surface of the protrusion. Accordingly, the whole protrusion can be removed through the secondary patterning process. In addition, the cutting surface 232 may have a linear shape when viewed in a plan view.

In addition, referring to FIG. 11, the burrs BU may be formed inside the back electrodes 210. In other words, the circumference of the cutting surface 233 may be formed more outwardly as compared with the circumference of the circles C.

Therefore, the width W1 of the cutting region CA may be greater than the width W2 of the non-cutting region NCA.

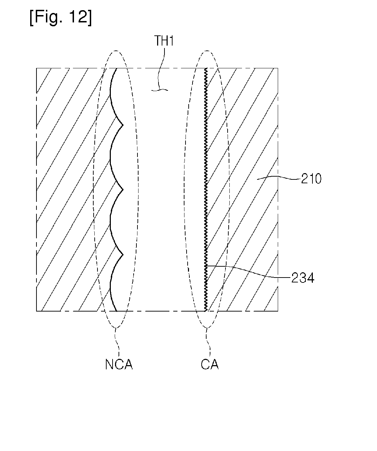

Referring to FIG. 12, the burr BU may be formed over the entire surface of one side of the first through hole TH1. Accordingly, the cutting surface 231 may be formed over the entire surface of one side of the first through hole TH1.

That is, the whole one side of the first through hole TH1 may correspond to the cutting area CA having the cutting surface and the whole opposite side of the first through hole TH1 facing the one side may correspond to the non-cutting area NCA.

The region having the burrs BU and/or the area of the region having the burrs BU may vary according to the intensity of a laser used in the primary patterning process and an area of the region on which the laser is irradiated. The region having the burrs BU and/or the area of the region having the burrs BU may vary according to the material of the support substrate 100 and the material of the back electrode layer 200.

The secondary patterning process can be performed by applying mechanical impact to the entire portion of the inner lateral side of the first through holes TH1 without checking the generation of the burr BU.

In addition, after the burrs BU have been checked by the naked eye of a person, the mechanical impact is applied to the region having the burrs BU so that the burrs BU can be removed.

Referring to FIG. 8, a light absorbing layer 300, a buffer layer 400, and a high resistance buffer layer 500 are formed on the back electrode layer 200.

The light absorbing layer 300 may be formed through a sputtering process or an evaporation scheme.

The light absorbing layer 300 may be formed through various schemes such as a scheme of forming a Cu(In,Ga)Se₂ (CIGS) based light absorbing layer 300 by simultaneously or separately evaporating Cu, In, Ga, and Se and a scheme of performing a selenization process after a metallic precursor layer has been formed.

Regarding the details of the selenization process after the formation of the metallic precursor layer, the metallic precursor layer is formed on the back electrode layer 200 through a sputtering process employing a Cu target, an In target, or a Ga target.

Thereafter, the metallic precursor layer is subject to the selenization process so that the Cu (In, Ga) Se₂ (CIGS) based light absorbing layer 300 is formed.

In addition, the sputtering process employing the Cu target, the In target, and the Ga target and the selenization process may be simultaneously performed.

Further, a CIS or a CIG based light absorbing layer 300 may be formed through the sputtering process employing only Cu and In targets or only Cu and Ga targets and the selenization process.

Thereafter, the buffer layer 400 may be formed by depositing CdS on the light absorbing layer 300 through a CBD (Chemical Bath Deposition) scheme.

Thereafter, the high resistance buffer layer 500 is formed by depositing zinc oxide on the buffer layer 400 through a sputtering process.

The buffer layer 400 and the high resistance buffer layer 500 are deposited with a low thickness. For example, the thickness of the buffer layer 400 and the high resistance buffer layer 500 is in the range of about 1 nm to about 80nm.

The light absorbing layer 300 includes a group I-III-VI compound. For example, the light absorbing layer 300 may have the CIGSS (Cu(IN,Ga)(Se,S)₂) crystal structure, the CISS (Cu(IN)(Se,S)₂) crystal structure or the CGSS (Cu(Ga)(Se,S)₂) crystal structure.

The energy bandgap of the light absorbing layer 300 may be in the range of about 1 eV to about 1.8eV.

In addition, a plurality of light absorbing parts are defined in the light absorbing layer 300 by the second through holes TH2. In other words, the light absorbing layer 300 is divided into the light absorbing parts through the second through holes TH2.

The buffer layer 400 is provided on the light absorbing layer 300. The buffer layer 400 includes CdS, and the energy bandgap of the buffer layer 400 is in the range of about 2.2eV to about 2.4eV.

The high resistance buffer layer 500 is provided on the buffer layer 400. The high resistance buffer layer 500 includes i-ZnO that is not doped with impurities. The energy bandgap of the high resistance buffer layer 500 is in the range of about 3.1 eV to about 3.3eV.

Thereafter, the second through holes TH2 are formed by removing portions of the light absorbing layer 300, the buffer layer 400, and the high resistance buffer layer 500.

The second through holes TH2 may be formed through a mechanical device such as a tip or a laser device.

For example, the light absorbing layer 300 and the buffer layer 400 may be patterned by a tip having a width in the range of about 40µm to about 180µm. In addition, the second through holes TH2 may be formed by a laser having a wavelength in the range of about 200nm to about 600nm.

In this case, the width of the second through holes TH2 may be in the range of about 100µm to about 200µm. In addition, the second through holes TH2 expose a portion of the top surface of the back electrode layer 200.

The second through holes TH2 is formed through the light absorbing layer 300. The second through holes TH2 are open regions to expose the top surface of the back electrode layer 200.

The second through holes TH2 are adjacent to the first through holes TH1. In other words, a portion of the second through holes TH2 is formed beside the first through holes TH1 when viewed in a plan view.

The width of the second through holes TH2 may be in the range of about 80µm to about 200µm.

Referring to FIG. 9, a window layer 600 is formed on the light absorbing layer 300 and formed in the second through holes TH2. In other words, the window layer 600 may be formed by depositing transparent conductive material on the high resistance buffer layer 500 and in the second through holes TH2.

In this case, the transparent conductive material is filled in the second through holes TH2, and a plurality of connection parts are formed inside the second through holes. In other words, the window layer 600 directly makes contact with the back electrode layer 200.

The window layer 600 includes an oxide. For example, the window layer 600 may include a zinc oxide, an indium tin oxide (ITO), or an indium zinc oxide (IZO).

For example, the window layer 600 may be formed by depositing Al doped zinc oxide. The window layer 600 may be formed through the sputtering process by using a target including Al doped zinc oxide.

The third through holes TH3 are formed by removing portions of the buffer layer 400, the high resistance buffer layer 500, and the window layer 600. Therefore, a plurality of windows and a plurality of cells C1, C2, ..., and CN are defined by patterning the window layer 600. The width of the third through holes TH3 may be in the range of about 80µm to about 200µm.

In order to form the solar cell apparatus according to the embodiment, the back electrode layer 200 is primarily patterned by using a laser, and secondarily patterned through a mechanical scheme. In this case, a portion of the back electrode layer 200 is spaced apart from the substrate through the primary patterning process, thereby causing burrs BU. In this case, the burrs BU are removed through the secondary patterning process.

Therefore, in the solar cell apparatus of the embodiment, the short and the leakage current caused by the burrs BU can be prevented. If the burrs BU are not removed, the back electrode layer 200 may be shorted with the window layer 600 through the light absorbing layer. Since the burrs BU are effectively removed according to the present embodiment, the solar cell apparatus according to the embodiment can represent improved electrical characteristics and high photoelectric conversion efficiency.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

### [Industrial Applicability]

As described above, according to solar photovolataic device and a production method thereor of the embodiment can use a field of solar photovolataic device.

## Claims

1. A solar cell apparatus comprising:
a substrate;
a back electrode layer on the substrate;
a light absorbing layer on the back electrode layer; and
a front electrode layer on the light absorbing layer,
wherein a through hole extends in one direction in the back electrode layer,
the through hole comprises:
a first area; and
a second area adjacent to the first area and having a cutting surface,
wherein roughness of the cutting surface is greater than roughness of an inner side of the first area.

2. The solar cell apparatus of claim 1, wherein the first area comprises first protrusions extending to an inner side of the through hole, and
the second area comprises second protrusions shorter than the first protrusions.

3. The solar cell apparatus of claim 2, wherein the cutting surface is formed at ends of the second protrusions.

4. The solar cell apparatus of claim 1, wherein the cutting surface has a concave shape.

5. The solar cell apparatus of claim 1, wherein the inner side of the first area has a concave shape.

6. The solar cell apparatus of claim 1, wherein a width of the second area is smaller than a width of the first area.

7. The solar cell apparatus of claim 1, wherein the light absorbing layer covers the cutting surface.

8. The solar cell apparatus of claim 1, wherein the back electrode layer comprises molybdenum.

9. a substrate;
a plurality of back electrode layers on the substrate;
light absorbing layers disposed on the back electrode layers, respectively; and
a plurality of front electrodes disposed on the light absorbing layers, respectively,
wherein the back electrodes comprises:
first protrusions extending in a lateral direction; and
second protrusions shorter than the first protrusions.

10. The solar cell apparatus of claim 9, wherein surface areas of the second protrusions are about 1% to about 50% based on surface areas of the first protrusions.

11. The solar cell apparatus of claim 9, wherein cutting surfaces are formed at ends of the second protrusions, respectively, and
roughness of each cutting surface is higher than roughness of a side between the first protrusions.

12. The solar cell apparatus of claim 9, wherein all bottom surfaces of the first protrusions and the second protrusions adhere to a top surface of the substrate.

13. The solar cell apparatus of claim 9, wherein the substrate comprises a glass substrate, and the back electrodes comprise molybdenum.

14. A method of fabricating a solar cell apparatus, the method comprising:
forming a back electrode layer on a substrate;
primarily patterning the back electrode layer using laser; and
secondarily patterning the back electrode layer in a mechanical scheme.

15. The method of claim 14, wherein the primary patterning of the back electrode layer comprises forming a through hole extending in one direction in the back electrode layer, and
the secondary patterning of the back electrode layer comprises applying mechanical impact to an inner side of the through hole.

16. The method of claim 14, wherein a part of the back electrode layer is spaced apart from the substrate in the primary patterning of the back electrode layer, and
the secondary patterning of the back electrode layer comprises removing a part of the back electrode layer spaced apart from the substrate.

17. The method of claim 14, wherein the primary patterning of the back electrode layer comprises forming a through hole exposing the substrate in the back electrode layer, and forming a plurality of protrusions protruding inward from an inner surface of the through hole, and
the secondary patterning of the back electrode layer comprises removing a part of the protrusions.

18. The method of claim 14, wherein the secondary patterning of the back electrode layer comprises:
inspecting a part of the back electrode layer spaced apart from the substrate; and
removing the part of the back electrode spaced apart from the substrate.
removing the portion of the back electrode layer spaced apart from the substrate.
